(19) Europäisches Patentamt
European Patent Office
Office européen des brevets

(11) EP 2 770 510 A1

(12) EUROPEAN PATENT APPLICATION
published in accordance with Art. 153(4) EPC

(43) Date of publication:
**27.08.2014 Bulletin 2014/35**

(21) Application number: **12841623.7**

(22) Date of filing: **16.10.2012**

(51) Int Cl.:
***H01B 3/00*** *(2006.01)* ***C08J 5/18*** *(2006.01)*
***C08K 3/24*** *(2006.01)* ***C08L 15/00*** *(2006.01)*
***H01B 3/12*** *(2006.01)* ***H01B 3/28*** *(2006.01)*
***H01L 41/08*** *(2006.01)* ***H01L 41/193*** *(2006.01)*
***H01L 41/45*** *(2013.01)* ***H02N 11/00*** *(2006.01)*
***H04R 17/00*** *(2006.01)*

(86) International application number:
**PCT/JP2012/076693**

(87) International publication number:
**WO 2013/058237 (25.04.2013 Gazette 2013/17)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **17.10.2011 JP 2011227935**

(71) Applicant: **Tokai Rubber Industries, Ltd.**
**Komaki-shi, Aichi 485-8550 (JP)**

(72) Inventors:
- **TAKAHASHI Wataru**
  **Komaki-shi**
  **Aichi 485-8550 (JP)**
- **YOSHIKAWA Hitoshi**
  **Komaki-shi**
  **Aichi 485-8550 (JP)**
- **TAKAMATSU Shigeaki**
  **Komaki-shi**
  **Aichi 485-8550 (JP)**
- **KUMAGAI Shinji**
  **Komaki-shi**
  **Aichi 485-8550 (JP)**

(74) Representative: **Müller-Boré & Partner**
**Patentanwälte PartG mbB**
**Friedenheimer Brücke 21**
**80639 München (DE)**

# (54) DIELECTRIC FILM AND TRANSDUCER USING SAME

(57) A dielectric film of the present invention includes an elastomer and barium titanate particles with a crystallinity of 80% or more. The elastomer and each of the barium titanate particles each have a functional group, the functional groups can react with each other, and through the reaction of the functional groups, a cross-linked structure with the elastomer and the barium titanate particles is formed. With this structure, the dielectric constant and volume resistivity of the dielectric film of the present invention are high. A transducer of the present invention includes the dielectric film and a plurality of electrodes with the dielectric film interposed therebetween. The transducer of the present invention is excellent in resistance to dielectric breakdown and can output a large force.

[FIG. 1]

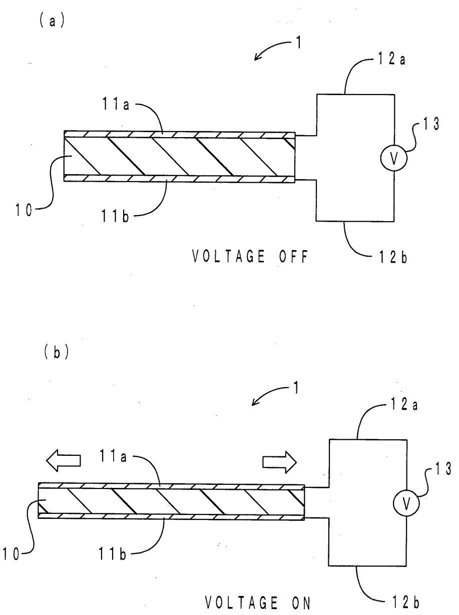


EP 2 770 510 A1

## Description

### TECHNICAL FIELD

The present invention relates to a transducer using an elastomer material, and in particular, to a dielectric film for use in the transducer.

### BACKGROUND ART

Transducers are known that perform conversion between mechanical energy and electric energy such as actuators, sensors, and electric power generating elements and that perform conversion between acoustic energy and electric energy such as speakers and microphones. In order to form a highly flexible, compact, and lightweight transducer, polymer materials such as dielectric elastomers are useful.

For example, as disclosed in Patent Document 1, an actuator can be formed by arranging a pair of electrodes on both sides in the thickness direction of a dielectric film formed of a dielectric elastomer. In actuators of this kind, when a voltage applied between the electrodes increases, an electrostatic attraction between the electrodes increases. The dielectric film interposed between the electrodes is thereby compressed in the thickness direction, leading to a reduced thickness of the dielectric film. When the film thickness decreases, the dielectric film accordingly expands in a direction parallel to the electrode surfaces. On the other hand, when the voltage applied between the electrodes is reduced, the electrostatic attraction between the electrodes decreases. A compressive force against the dielectric film in the thickness direction thereby decreases, and the film thickness increases due to the elastic restoring force of the dielectric film. When the film thickness increases, the dielectric film accordingly contracts in a direction parallel to the electrode surfaces. The actuator thus expands and contracts the dielectric film, thereby driving a member to be driven.

In order to increase a force and displacement output from the actuator, it is required that the dielectric constant and volume resistivity of the dielectric film are increased. Therefore, as materials for the dielectric film, acrylic rubber and nitrile rubber that have a high dielectric constant and silicone rubber that has high resistance to dielectric breakdown are used.

#### Related Art Documents

#### Patent Documents

Patent Document 1: Publication of Japanese Translation of PCT Application No. 2003-506858
Patent Document 2: Japanese Patent Application Publication No. 2009-227985
Patent Document 3: Japanese Patent Application Publication No. 2011-084712
Patent Document 4: Japanese Patent Application Publication No. 2005-306691

### SUMMARY OF THE INVENTION

#### Problem to be Solved by the Invention

Because silicone rubber includes siloxane bonds as a backbone, its electric resistance is high. In a dielectric film formed of silicone rubber, therefore, dielectric breakdown is less likely to occur even when a large voltage is applied. However, the polarity of silicone rubber is low. In other words, the dielectric constant of the silicone rubber is small. Thus, when an actuator is formed employing a dielectric film formed of silicone rubber, an electrostatic attraction with respect to an applied voltage is small. It is therefore impossible to obtain a desired force and displacement using a practical voltage.

On the other hand, the dielectric constant of acrylic rubber and nitrile rubber is higher than that of silicone rubber. Thus, when acrylic rubber or the like is used for the material of the dielectric film, the electrostatic attraction with respect to the applied voltage increases, compared to a case where silicone rubber is used. However, the electric resistance of acrylic rubber or the like is lower than that of silicone rubber. Therefore, the dielectric film is more susceptible to dielectric breakdown. Because a current passes through the dielectric film during voltage application (so-called a leakage current), electric charges are not prone to accumulate in the vicinity of the interface between the dielectric layer and the electrodes. Despite its high dielectric constant, therefore, the electrostatic attraction decreases, so a satisfactory force and displacement can not be obtained. It is thus difficult by an elastomer alone to achieve a dielectric film that satisfies both electrostatic attraction and resistance to dielectric breakdown.

In this regard, Patent Document 2 discloses a dielectric film in which high-dielectric ceramics powder such as

barium titanate is blended into base rubber. The inventors of the present invention have developed, as a material of a dielectric film, an elastomer material in which an inorganic filler such as barium titanate is blended into an elastomer cross-linked by an organometallic compound (see Patent Document 3). Blending an inorganic filler into an elastomer inhibits the flow of electrons, which increases the electric resistance. However, in the conventional elastomer material, the inorganic filler is not directly chemically bonded to the elastomer. Therefore, an insulating network through bonds between the elastomer and the inorganic filler cannot be formed, so the effect of increasing electric resistance is insufficient. There is a risk of degradation in resistance to dielectric breakdown caused by the occurrence of discharge in minute interstices between the elastomer and the inorganic filler during voltage application. Furthermore, the higher the crystallinity of barium titanate blended as the inorganic filler, the higher the dielectric constant and volume resistivity thereof. However, the above Patent Documents 2 and 3 do not discuss the crystallinity of barium titanate.

The present invention has been achieved in view of the above circumstances, and an object thereof is to provide a dielectric film having a high dielectric constant and volume resistivity. Another object thereof is to provide a transducer including the dielectric film that is excellent in resistance to dielectric breakdown and can output a large force.

Means for Solving the Problem

(1) A dielectric film according to the present invention is a dielectric film for use in a transducer and characterized by including an elastomer and barium titanate particles with a crystallinity of 80% or more, wherein the elastomer and each of the barium titanate particles each have a functional group, the functional groups optionally react with each other, and through the reaction of the functional groups, a cross-linked structure with the elastomer and the barium titanate particles is formed.

In the dielectric film according to the present invention, a cross-linked structure with the elastomer and the barium titanate particles is formed. More specifically, the flow of electrons is inhibited by an insulating network formed by the elastomer and the barium titanate particles. Therefore, the electric resistance of the dielectric film according to the present invention is high. The elastomer and the barium titanate particles are chemically bonded to each other. Thus, there are no interstices between them. During voltage application, therefore, dielectric breakdown due to discharge is less likely to occur. Furthermore, because the barium titanate particles are incorporated in a three-dimensional network structure of the elastomer, the barium titanate particles are less prone to aggregate. In other words, the barium titanate particles are dispersed in the elastomer uniformly in a state of isolated primary particles, not in a state of aggregated secondary particles. The passage of electrons can be therefore inhibited more effectively. Because the film quality of the dielectric film is uniform, the elongation of the dielectric film during voltage application becomes uniform, so that dielectric breakdown starting from the barium titanate particles is less likely to occur.

The crystallinity of the barium titanate particles is 80% or more. Because of the high crystallinity, the dielectric constant and volume resistivity of the barium titanate particles are high. By using the barium titanate particles having high crystallinity, the dielectric constant and volume resistivity of the dielectric film according to the present invention can be further increased. The crystallinity can be measured by an X-ray diffraction (XRD) apparatus. More specifically, an obtained XRD pattern is separated into peak intensity originated from a crystalline component and halo intensity originated from an amorphous component, and using their integral intensity, the crystallinity is calculated from the following Formula (1):

$$\text{Crystallinity (\%)} = Sc/(Sc+Sa)\times 100 \qquad (1)$$

[Sc: Integral intensity of crystalline peak, Sa: Integral intensity of amorphous halo]

Thus, using the barium titanate particles having high crystallinity, the cross-linked structure with the elastomer and the barium titanate particles is formed to uniformly distribute the barium titanate particles in the elastomer, thereby significantly improving the dielectric constant and volume resistivity of the dielectric film. With the dielectric film according to the present invention, because of the high dielectric constant, a large electrostatic attraction with respect to an applied voltage can be generated. Moreover, because of the high volume resistivity, a leakage current is little, and a large number of electric charges can be accumulated in the vicinity of the boundary between the dielectric film and an electrode. With a transducer including the dielectric film according to the present invention, therefore, a larger force and displacement can be obtained by a practical voltage. Because the dielectric film according to the present invention has high resistance to dielectric breakdown, a larger force and displacement can be obtained by applying a higher voltage.

(2) The transducer according to the present invention is characterized by including the above dielectric film according

to the present invention and a plurality of electrodes that are arranged with the dielectric film interposed therebetween. The transducer according to the present invention includes the above dielectric film according to the present invention. As described above, the dielectric constant and volume resistivity of the dielectric film according to the present invention are high. Therefore, when a voltage is applied to the dielectric film according to the present invention, a large electrostatic attraction is generated. Thus, with the transducer according to the present invention, a larger force and displacement can be obtained by a practical voltage. In addition, because the resistance to dielectric breakdown of the dielectric film is high, a larger force and displacement can be obtained by applying a higher voltage.

BRIEF DESCRIPTION OF THE DRAWINGS

[FIG. 1] FIG. 1 illustrates schematic sectional views of an actuator of a first embodiment of a transducer according to the present invention: (a) illustrates a voltage OFF state; (b) illustrates a voltage ON state.
[FIG. 2] FIG. 2 is a front-side elevation view of an actuator mounted on a measuring apparatus.
[FIG. 3] FIG. 3 is a III-III sectional view of FIG. 2.
[FIG. 4] FIG. 4 is a perspective view of a speaker as a second embodiment of the transducer according to the present invention.
[FIG. 5] FIG. 5 is a V-V sectional view of FIG. 4.

Description of the Reference Numerals

1: actuator (transducer), 10: dielectric film, 11a, 11b: electrode, 12a, 12b: electric wire, 13: power source.
4: speaker (Transducer), 40a: first outer frame, 40b: second outer frame, 41 a: first inner frame, 41b: second inner frame, 42a: first dielectric film, 42b: second dielectric film, 43a: first outer electrode, 43b: second outer electrode, 44a: first inner electrode, 44b: second inner electrode, 45a: first diaphragm, 45b: second diaphragm, 430a, 430b, 440a, 440b: terminal, 460: bolt, 461: nut, 462: spacer.
5: actuator, 50: dielectric film, 51a, 51b: electrode, 52: upper chuck, 53: lower chuck.

MODES FOR CARRYING OUT THE INVENTION

Embodiments of a dielectric film and a transducer according to the present invention will be described. The dielectric film and the transducer according to the present invention are not limited to the embodiments below and may be embodied in various ways in which modifications, improvements, etc. that could be made by those skilled in the art are made without departing from the scope of the present invention.

<Dielectric Film>

The dielectric film according to the present invention includes an elastomer and barium titanate particles with a crystallinity of 80% or more.

[Elastomer]

The elastomer is not particularly limited as long as it has a functional group that can react with the functional group of the barium titanate particles. As described later, the functional group of the barium titanate particles includes at least either one of an alkoxy group (-OR) and a hydroxy group (-OH). Thus, the elastomer preferably includes a functional group that can react with these functional groups, specifically, one or more groups selected from a hydroxy group (-OH), an amino group ($-NH_2$, $-NHR_1$, and $-NR_1R_2$), a carboxy group (-COOH), a thiol group (-SH), and a halogenated alkyl group (-RX) (R, $R_1$, and $R_2$ are each an alkyl group, and X is a halogen atom).
The elastomer includes cross-linked rubbers and thermoplastic elastomers. One of these alone or two or more thereof in combination may be used. The elastomer may be appropriately selected in accordance with performance required for the transducer. For example, in view of increasing an electrostatic attraction generated during voltage application, the elastomer is preferably high in polarity, that is, high in dielectric constant. Specifically, the elastomer preferably has a dielectric constant of 2.8 or more (with a measuring frequency of 100 Hz). Examples of the elastomer having a high dielectric constant include nitrile rubber (NBR), hydrogenated nitrile rubber (H-NBR), acrylic rubber, natural rubber, isoprene rubber, ethylene-vinyl acetate copolymer, ethylene-vinyl acetate-acrylic ester copolymer, butyl rubber, styrene-butadiene rubber, fluorocarbon rubber, epichlorohydrin rubber, chloroprene rubber, chlorinated polyethylene, chlorosulfonated polyethylene, and urethane rubber. When the elastomer has no functional group, the elastomer may

be modified by, for example, introducing a functional group. Preferred examples of the modified elastomer include carboxy group-modified nitrile rubber (X-NBR) and carboxy group-modified hydrogenated nitrile rubber (HX-NBR). For X-NBR and HX-NBR, a preferred elastomer has an acrylonitrile content (combined AN amount) of 33% by mass or more. The combined AN amount is the mass ratio of acrylonitrile with the entire mass of rubber being 100% by mass.

An elastomer having a low dielectric constant but a high electric resistance is preferable in that it is less likely to undergo dielectric breakdown during voltage application. Examples of the elastomer having a high electric resistance include silicone rubber and ethylene-propylene-diene copolymer. When the elastomer has no functional group, a functional group may be appropriately introduced.

The thermoplastic elastomer is suitable because no cross-linking agent is used, and hence impurities are less likely to be introduced. Examples of the thermoplastic elastomer include styrene-based elastomers (SBS, SEBS, and SEPS), olefin-based elastomers (TPO), PVC-based elastomers (TPVC), urethane-based elastomers (TPU), ester-based elastomers (TPEE), and amide-based elastomers (TAPE), and copolymers and blends of theses elastomers.

[Barium Titanate Particles]

The barium titanate particles with a crystallinity of 80% or more are used. The barium titanate particles that are manufactured by a manufacturing method, which will be described later, have on their surface at least either one of an alkoxy group (-OR) and a hydroxy group (-OH) as a functional group that can react with the functional group of the elastomer. Through the reaction of the functional group of the barium titanate particles and the functional group of the elastomer, a cross-linked structure is formed. In other words, the barium titanate particles function as a cross-linking agent.

In view of the uniformity of the dielectric film, the particle diameter of the barium titanate particles is preferably smaller. The barium titanate particles having a smaller particle diameter are dispersed in the elastomer uniformly, thereby forming a dense insulating network and making the film quality of the dielectric film uniform. Therefore, a leakage current during voltage application is reduced, and the elongation of the dielectric film becomes uniform, so that dielectric breakdown starting from the barium titanate particles is less likely to occur. On the other hand, the larger the particle diameter of the barium titanate particles, the higher the dielectric constant thereof. Thus, in view of the dielectric constant of the dielectric film, the diameter of the barium titanate particles is preferably larger. From the foregoing, in view of these contradictory advantages, the particle diameter of the barium titanate particles may be appropriately determined such that the dielectric film has a desired dielectric constant, volume resistivity, flexibility, and the like.

For example, the particle diameter of the barium titanate particles is preferably 8 nm or more and 120 nm or less. When the particle diameter is less than 8 nm, the effect of increasing the dielectric constant is small. It is preferably 10 nm or more. When the particle diameter exceeds 120 nm, the effect of increasing the volume resistivity is small. It is preferably 60 nm or less.

In this specification, unless otherwise specified, the median diameter is employed as the particle diameter of the barium titanate particles. The particle diameter of the barium titanate particles in the dielectric film can be measured through observation with a transmission electron microscope (TEM). The particle diameter may also be measured by a scanning probe microscope (SPM), a small angle X-ray scattering method, and X-ray diffraction (XRD).

As describe below, the barium titanate particles can be manufactured by a sol-gel method using a high-concentration precursor. In this case, it is estimated that the particle diameter of the barium titanate particles in an obtained gel and the particle diameter of the barium titanate particles in the dielectric film are equal. The particle diameter of the barium titanate particles in the gel may be therefore employed as the particle diameter of the barium titanate particles in the dielectric film. The particle diameter of the barium titanate particles in the gel can be measured by using, for example, a laser diffraction/scattering particle diameter/particle size distribution measuring apparatus manufactured by Nikkiso Co., Ltd. Also, when the gel is dried, the particle diameter of the barium titanate particles can be measured through observation with a scanning electron microscope (SEM).

The content of the barium titanate particles may be appropriately determined in view of the dielectric constant, volume resistivity, flexibility, and the like of the dielectric film. For example, the content of the barium titanate particles may be 10 parts by mass or more and 500 parts by mass or less with respect to 100 parts by mass of the elastomer. When the content of the barium titanate particles is less than 10 parts by mass, the effect of increasing the dielectric constant and volume resistivity is small. In contrast, when the content of the barium titanate particles exceeds 500 parts by mass, the modulus of elasticity increases, thereby impairing flexibility.

As described above, the higher the crystallinity of barium titanate, the higher the dielectric constant and volume resistivity thereof. Known methods for manufacturing barium titanate include a solid phase reaction method, a hydrothermal synthesis method, and a sol-gel method. Among these, by the solid phase reaction method, barium titanate having high crystallinity can be obtained but the particles are likely to agglomerate through high-temperature baking. Therefore, even when the particles after baking are pulverized, only particles having a larger particle diameter can be obtained. When the particle diameter of barium titanate is larger, it is difficult to uniformly disperse the barium titanate in the entire elastomer. When particles having a larger particle diameter are present, the elongation of the dielectric film

during voltage application is likely to become nonuniform. In this case, defects starting from the particle are likely to occur, which may degrade resistance to dielectric breakdown. Through baking, the number of the functional groups on the particle surface decreases. When the number of the functional groups on the particle surface is small, the particles are less likely to be bonded to the elastomer. Therefore, a cross-linked structure of the elastomer and the barium titanate particles cannot be formed.

On the other hand, by the normal hydrothermal synthesis method and the normal sol-gal method, only particles having low crystallinity can be obtained because a hydroxy group and the like remain within the particles. When the obtained particles are baked, the crystallinity can be increased, but the particle diameter increases and the number of functional groups on the particle surface decreases as in the case with the solid phase reaction method.

Thus, the barium titanate particles to be blended into the dielectric film according to the present invention are preferably manufactured by a hydrothermal synthesis method using supercritical water disclosed in Japanese Patent No. 3925932 or a sol-gal method using a high-concentration precursor disclosed in Patent Document 4.

For example, according to the hydrothermal synthesis method using supercritical water, the barium titanate particles are manufactured by supplying a metal complex containing barium and titanium to a reaction environment in a supercritical water state and leaving it there for a given period of time. By this method, it is possible to easily manufacture barium titanate particles with a crystallinity of 80% or more and a particle diameter of 120 nm or less.

For the metal complex serving as a raw material, a plurality of alkoxides and hydroxides of a single metal including barium or titanium may be combined so that they form a perovskite compound composition, or a complex alkoxide containing both barium and titanium may be used. Examples of the barium alkoxide include barium methoxide, barium ethoxide, barium propoxide, and barium butoxide. Examples of the titanium alkoxide include titanium methoxide, titanium ethoxide, titanium propoxide, and titanium butoxide. Examples of the complex alkoxide include barium titanium methoxide, barium titanium ethoxide, barium titanium propoxide, and barium titanium butoxide.

According to the sol-gel method using a high-concentration precursor, the barium titanate particles are manufactured by adding dropwise a mixed solution of water and a polar organic solvent, in which the concentration of the polar organic solvent is 15% by mole or more, to a precursor solution with a concentration of an alkoxide containing barium and titanium of 0.5 mol/l or more, such that the molar ratio of the water in the mixed solution is at least four times the molar ratio of the titanium in the precursor solution, to hydrolyze the alkoxide, and maintaining it at a temperature of 10°C or more. By this method, it is possible to easily manufacture barium titanate particles with a crystallinity of 80% or more and a particle diameter of 120 nm or less.

For the alkoxide serving as a raw material, a plurality of alkoxides of a single metal including barium or titanium may be combined so that they form a perovskite compound composition, or a complex alkoxide containing both barium and titanium may be used. Examples of the barium alkoxide include barium methoxide, barium ethoxide, barium propoxide, and barium butoxide. Examples of the titanium alkoxide include titanium methoxide, titanium ethoxide, titanium propoxide, and titanium butoxide. Examples of the complex alkoxide include barium titanium methoxide, barium titanium ethoxide, barium titanium propoxide, and barium titanium butoxide.

An alkoxide containing barium and titanium is dissolved in, for example, a mixed solvent of methanol and 2-methoxy ethanol (with a volume ratio of 3 to 2) to prepare a precursor solution with an alkoxide concentration of 0.5 mol/l or more. Any solvent that can dissolve the alkoxide in a concentration of 0.5 mol/l or more can be used, and alcohol-based solvents such as methanol and ethanol and ketone-based solvents such as methyl ethyl ketone and acetone may be used singly or in combination.

For the polar organic solvent for the mixed solution to be added dropwise to the precursor solution, alcohol-based, ketone-based, and ether-based solvents may be used. In order to control a rapid hydrolysis reaction and polycondensation reaction, the dropwise addition of the mixed solution may be performed with the precursor solution cooled to about -30°C. A solution after hydrolysis is then heated to about 10°C or more and held under the temperature for a given period of time (aging treatment). The holding temperature is preferably 30°C or more. By performing the aging treatment, the hydroxy group and the like remaining within the particles can be reduced to improve crystallinity. During the aging treatment, irradiation of the solution after hydrolysis with ultrasonic waves facilitates the crystallization reaction of the barium titanium particles, thereby shortening the time for the aging treatment.

[Other Components]

The dielectric film according to the present invention may contain other components in addition to the elastomer and the barium titanium particles. Examples of the other components include cross-linking agents, reinforcing agents, plasticizers, antioxidants, and colorants. In the dielectric film according to the present invention, a cross-linked structure is formed through the reaction of the functional group of the barium titanate particles and the functional group of the elastomer without any cross-linking agent. However, addition of a cross-linking agent can further facilitate a cross-linking reaction.

<Method for Manufacturing Dielectric Film>

A method for manufacturing the dielectric film according to the present invention is not particularly limited. For example, a pre-crosslinked polymer of an elastomer, barium titanate powder, and additives, if necessary, may be mixed and kneaded by rolls or a kneader and be formed into a thin-film under predetermined conditions. Alternatively, a solution containing a pre-crosslinked polymer of an elastomer, barium titanate powder, and additives, if necessary, is applied onto a substrate to be cured under predetermined conditions. A dispersion liquid of barium titanate particles in which, not barium titanate powder, but a gel manufactured by the above sol-gel method using a high-concentration precursor is dispersed in a solvent may be used.

<Transducer>

The transducer according to the present invention includes the dielectric film according to the present invention and a plurality of electrodes with the dielectric film interposed therebetween. The configuration of and method for manufacturing the dielectric film according to the present invention are as described above, so the description thereof will be omitted here. In the transducer according to the present invention, a preferable embodiment of the dielectric film according to the present invention is preferably employed.

The thickness of the dielectric film may be appropriately determined depending on its use or the like. For example, when the transducer according to the present invention is used as an actuator, the thickness of the dielectric film is preferably small in view of the size reduction and lower-potential drive of the actuator, increase in the displacement thereof, and the like. In this case, also taking into account resistance to dielectric breakdown or the like, the thickness of the dielectric film is preferably 1 $\mu$m or more and 1000 $\mu$m (1 mm) or less. The more preferable range is 5 $\mu$m or more and 200 $\mu$m or less.

In the transducer according to the present invention, the material of the electrodes is not particularly limited. The electrodes are preferably expandable and contractible in accordance with the deformation of the dielectric film. In this case, the deformation of the dielectric film is hard to be restricted by the electrodes. Therefore, desired output is likely to be obtained in the transducer according to the present invention. For example, the electrodes can be formed from a conductive paste or a conductive coating in which a conductive material is mixed into a binder such as oil and an elastomer. Examples of the conductive material include carbon material such as carbon black, ketjen black, a carbon nanotube, and graphene, and metallic powder of silver or the like. The electrodes may also be formed by knitting carbon fibers or metallic fibers in mesh.

When the transducer according to the present invention is formed in a stacked structure in which a plurality of dielectric films and electrodes are alternately stacked, a larger force can be generated. Therefore, when the stacked structure is employed, for example, the output of an actuator can be increased. A member to be driven can be thereby driven by a larger force.

Hereinafter, embodiments in which the transducer according to the present invention is embodied as an actuator and a speaker will be described.

[First Embodiment]

As a first embodiment of the transducer according to the present invention, an embodiment of an actuator will be described. FIG. 1 illustrates schematic sectional views of the actuator of the present embodiment: (a) illustrates a voltage OFF state; (b) illustrates a voltage ON state.

As illustrated in FIG. 1, an actuator 1 includes a dielectric film 10, electrodes 11a, 11b, and electric wires 12a, 12b. The dielectric film 10 contains carboxy group-modified hydrogenated nitrile rubber (HX-NBR) and barium titanate particles. The crystallinity of the barium titanate particles is 95%, and the median diameter thereof is 20 nm. A cross-linked structure is formed by HX-NBR and the barium titanate particles. The barium titanate particles are dispersed in HX-NBR uniformly. The electrode 11 a is arranged so as to cover nearly the entire upper surface of the dielectric film 10. Similarly, the electrode 11b is arranged so as to cover nearly the entire lower surface of the dielectric film 10. The electrodes 11a, 11b are connected to a power source 13 through the electric wires 12a, 12b, respectively.

When the OFF state is switched to the ON state, a voltage is applied between the pair of electrodes 11a, 11b. Through the application of voltage, the thickness of the dielectric film 10 decreases and the dielectric film 10 expands accordingly in a direction parallel to the surfaces of the electrodes 11a, 11b as illustrated by the white arrow in FIG. 1 (b). The actuator 1 thereby outputs driving forces in the up and down direction and right and left direction in the figure.

In the present embodiment, the flow of electrons in the dielectric film 10 is interrupted by an insulating network formed by HX-NBR and the barium titanate particles, and the crystallinity of the barium titanate particles is high. Therefore, the dielectric constant and volume resistivity of the dielectric film 10 are high. When a voltage is applied to the dielectric film 10, therefore, a large electrostatic attraction is generated. Thus, with the actuator 1, a large force and displacement

can be obtained by a practical voltage. Because resistance to dielectric breakdown of the dielectric film 10 is high, a larger force and displacement can be obtained by applying a higher voltage.

[Second Embodiment]

As a second embodiment of the transducer according to the present invention, an embodiment of a speaker will be described. First, the configuration of the speaker of the present embodiment will be described. FIG. 4 illustrates a perspective view of the speaker of the present embodiment. FIG. 5 illustrates a V-V sectional view of FIG. 4. As illustrated in FIG. 4 and FIG. 5, a speaker 4 includes a first outer frame 40a, a first inner frame 41a, a first dielectric film 42a, a first outer electrode 43a, a first inner electrode 44a, a first diaphragm 45a, a second outer frame 40b, a second inner frame 41b, a second dielectric film 42b, a second outer electrode 43b, a second inner electrode 44b, a second diaphragm 45b, eight bolts 460, eight nuts 461, and eight spacers 462.

The first outer frame 40a and the first inner frame 41 a are each formed of resin and shaped in a ring. The first dielectric film 42a is shaped in a circular thin film. The first dielectric film 42a is arranged between the first outer frame 40a and the first inner frame 41 a in a stretched state. In other words, the first dielectric film 42a is held and fixed by the front-side first outer frame 40a and the back-side first inner frame 41 a with a predetermined tension ensured. The first dielectric film 42a contains HX-NBR and barium titanate particles. The crystallinity of the barium titanate particles is 95%, and the median diameter thereof is 20 nm. A cross-linked structure is formed by HX-NBR and the barium titanate particles. The barium titanate particles are dispersed in HX-NBR uniformly. The first diaphragm 45a is formed of resin and shaped in a disc. The first diaphragm 45a has a diameter smaller than that of the first dielectric film 42a. The first diaphragm 45a is arranged at nearly the center of the front side of the first dielectric film 42a.

The first outer electrode 43a is shaped in a ring. The first outer electrode 43a is affixed to the front side of the first dielectric film 42a. The first inner electrode 44a is also shaped in a ring. The first inner electrode 44a is affixed to the back side of the first dielectric film 42a. The first outer electrode 43a and the first inner electrode 44a are arranged back-to-back in the front and back direction with the first dielectric film 42a held therebetween. Both the first outer electrode 43a and the first inner electrode 44a are formed of a conductive coating prepared by mixing and dispersing carbon black in an acrylic rubber polymer solution. As illustrated in FIG. 5, the first outer electrode 43a includes a terminal 430a. The first inner electrode 44a includes a terminal 440a. An external voltage is applied to the terminals 430a and 440a.

The configuration, material, and shape of the second outer frame 40b, the second inner frame 41b, the second dielectric film 42b, the second outer electrode 43b, the second inner electrode 44b, and the second diaphragm 45b (that are collectively called a "second member" below) are the same as the configuration, material, and shape of the first outer frame 40a, the first inner frame 41 a, the first dielectric film 42a, the first outer electrode 43a, the first inner electrode 44a, and the first diaphragm 45a (that are collectively called a "first member" below). The arrangement of the second member is symmetrical with the arrangement of the first member in the front and back direction. Simply describing, the second dielectric film 42b is shaped in a circular thin film and arranged between the second outer frame 40b and the second inner frame 41b in a stretched state. The second dielectric film 42b contains HX-NBR and barium titanate particles. The second diaphragm 45b is arranged at nearly the center of the front side of the second dielectric film 42b. The second outer electrode 43b is affixed to the front side of the second dielectric film 42b. The second inner electrode 44b is affixed to the back-side of the second dielectric film 42b. An external voltage is applied to a terminal 430b of the second outer electrode 43b and a terminal 440b of the second inner electrode 44b.

The first member and the second member are fixed by the eight bolts 460 and the eight nuts 461 through the eight spacers 462. Sets of "the bolt 460, the nut 461, and the spacer 462" are arranged spaced apart by a predetermined interval in the circumferential direction of the speaker 4. The bolt 460 passes through the first member and the second member, extending from the front side of the first outer frame 40a to the front side of the second outer frame 40b. The nut 461 is screwed on the distal end of the bolt 460. The spacer 462 is formed of resin and annually fit around the shaft of the bolt 460. The spacer 462 ensures certain spacing between the first inner frame 41a and the second inner frame 41b. The back side of the central part of the first dielectric film 42a (the back side of the part on which the first diaphragm 45a is arranged) and the back side of the central part of the second dielectric film 42b (the back side of the part on which the second diaphragm 45b is arranged) are bonded to each other. Therefore, a biasing force is accumulated in the first dielectric film 42a in a direction shown by the white arrow Y1a in FIG. 5. A biasing force is accumulated in the second dielectric film 42b in a direction shown by the white arrow Y1b in FIG. 5.

Next, the motion of the speaker of the present embodiment will be described. Through the terminals 430a and 440a, and the terminals 430b and 440b, a predetermined voltage (an offset voltage) is applied to the first outer electrode 43 a and the first inner electrode 44a, and the second outer electrode 43b and the second inner electrode 44b in the initial state (an offset state). When the speaker 4 is in operation, opposite-phase voltages are applied to the terminals 430a and 440a, and the terminals 430b and 440b. For example, when an offset voltage of + 1 V is applied to the terminals 430a and 440a, the film thickness of the part, in the first dielectric film 42a, arranged between the first outer electrode 43a and the first inner electrode 44a decreases, and the part expands in the radial direction. At the same time, an

opposite-phase voltage (an offset voltage of -1V) is applied to the terminals 430b and 440b. Then, the film thickness of the part, in the second dielectric film 42b, arranged between the second outer electrode 43b and the second inner electrode 44b increases, and the part contracts in the radial direction. Thus, the second dielectric film 42b elastically deforms through its own biasing force in the direction shown by the white arrow Y1b in FIG. 5, while pulling the first dielectric film 42a. In contrast, when an offset voltage of + 1 V is applied to the terminals 430b and 440b, and an opposite-phase voltage (an offset voltage of -1 V) is applied to the terminals 430a and 440a, the first dielectric film 42a elastically deforms through its own biasing force in the direction shown by the white arrow Y1a in FIG. 5, while pulling the second dielectric film 42b. By thus vibrating the first diaphragm 45a and the second diaphragm 45b to vibrate air, sound is generated.

Next, the effect of the speaker 4 of the present embodiment will be described. In the present embodiment, the dielectric constants of the first dielectric film 42a and the second dielectric film 42b are high. Therefore, an electrostatic attraction with respect to an applied voltage is high. Also, the volume resistivities of the first dielectric film 42a and the second dielectric film 42b are high. Therefore, a large number of electric charges can be accumulated in the vicinity of the boundary between the first dielectric film 42a and the first outer electrode 43a and the vicinity of the boundary between the first dielectric film 42a and the first inner electrode 44a. Similarly, a large number of electric charges can be accumulated in the vicinity of the boundary between the second dielectric film 42b and the second outer electrode 43b and the vicinity of the boundary between the second dielectric film 42b and the second inner electrode 44b. Thus, the displacement of the first dielectric film 42a and the second dielectric film 42b increases, thereby vibrating the first diaphragm 45a and the second diaphragm 45b with large amplitude. The sound pressure of the speaker 4 therefore increases.

Examples

Next, the present invention will be described more specifically with reference to the examples.

<Manufacture of Dielectric Film>

[Example 1]

Carboxy group-modified hydrogenated nitrile rubber ("Therban (trademark) XT8889" manufactured by LANXESS) was dissolved in acetylacetone to prepare a polymer solution with a solid content concentration of 12% by mass. Next, 120 parts by mass of a dispersion liquid of barium titanate particles ("Application liquid specialty Titabari 20 nm" with a median diameter of 20 nm and a crystallinity of 95% of the barium titanate particles manufactured by JGC Catalysts and Chemicals Ltd.) were mixed into 100 parts by mass of the prepared polymer solution to prepare a mixed solution. The prepared mixed solution was applied onto a substrate and dried, then, heated at 150°C for about 60 minutes to obtain a dielectric film. The film thickness of the dielectric film was about 20 μm, and the content of the barium titanate particles was 120 parts by mass with respect to 100 parts by mass of the elastomer (HX-NBR). The manufactured dielectric film was named the dielectric film of Example 1.

[Comparative Example 1]

A dielectric film made of HX-NBR was manufactured in the same manner as in Example 1 except that the dispersion liquid of barium titanate particles was not blended. The manufactured dielectric film was named the dielectric film of Comparative Example 1.

[Example 2]

A dielectric film was manufactured in the same manner as in Example 1 except that a cross-linking agent was blended and the blend amount of the dispersion liquid of barium titanate particles was reduced. Specifically, 53 parts by mass of the dispersion liquid of barium titanate particles (the same as the above) was mixed into 100 parts by mass of a polymer solution in which carboxy group-modified hydrogenated nitrile rubber (the same as the above) was dissolved in acetylacetone, and in addition, 5 parts by mass of an acetylacetone solution of tetrakis(2-ethylhexyloxy)titanium (with a concentration of 20% by mass) as a cross-linking agent was added thereto to prepare a mixed solution. The prepared mixed solution was applied onto a substrate and dried, then, heated at 150°C for about 60 minutes to obtain a dielectric film. The film thickness of the dielectric film was about 20 μm, and the content of barium titanate particles was 53 parts by mass with respect to 100 parts by mass of elastomer (HX-NBR). The manufactured dielectric film was named the dielectric film of Example 2.

[Comparative Example 2]

A dielectric film was manufactured in the same manner as in Example 2 except that, in place of the dispersion liquid of barium titanate particles, barium titanate powder A ("BT-150" with a crystallinity of 95% and an average diameter of 150 nm manufactured by KCM Corporation) manufactured by a conventional hydrothermal method was blended. The content of the barium titanate particles was 53 parts by mass with respect to 100 parts by mass of elastomer (HX-NBR). The manufactured dielectric film was named the dielectric film of Comparative Example 2.

[Example 3]

A dielectric film was manufactured in the same manner as Example 1 except that, in place of the dispersion liquid of barium titanate particles, 53 parts by mass of barium titanate powder B manufactured by the following hydrothermal synthesis method using supercritical water was blended. The content of the barium titanate particles was 53 parts by mass with respect to 100 parts by mass of elastomer (HX-NBR). The manufactured dielectric film was named the dielectric film of Example 3.

With a circulation type supercritical hydrothermal synthesis apparatus (manufactured by ITEC Co., Ltd.), 0.12 mol/l of a barium hydroxide solution and 0.1 mol/l of a titanium oxide solution ("STS-01" manufactured by Ishihara Sangyo Kaisha, Ltd.) were mixed with water in a supercritical state to cause them to react for 0.5 seconds. The barium titanate powder B with a median diameter of 12 nm and a crystallinity of 98% was thus manufactured.

[Example 4]

Barium titanate powder C was manufactured by setting the reaction time with the water in a supercritical state to 2 seconds in the hydrothermal synthesis method using supercritical water in Example 3. The median diameter of the barium titanate powder C was 60 nm, and the crystallinity thereof was 98%. A dielectric film was manufactured in the same manner as in Example 1 except that, in place of the dispersion liquid of barium titanate particles, 53 parts by mass of the barium titanate powder C was blended. The content of the barium titanate particles was 53 parts by mass with respect to 100 parts by mass of elastomer (HX-NBR). The manufactured dielectric film was named the dielectric film of Example 4.

[Example 5]

A dielectric film was manufactured in the same manner as Example 3 except that 5 parts by mass of an acetylacetone solution of tetrakis(2-ethylhexyloxy)titanium (with a concentration of 20% by mass) as a cross-linking agent was further added. The manufactured dielectric film was named the dielectric film of Example 5.

[Example 6]

A dielectric film was manufactured in the same manner as in Example 4 except that 5 parts by mass of an acetylacetone solution of tetrakis(2-ethylhexyloxy)titanium (with a concentration of 20% by mass) as a cross-linking agent was further added. The manufactured dielectric film was named the dielectric film of Example 6.

<Physical Properties of Dielectric Film>

[Volume Resistivity]

The volume resistivities of the manufactured dielectric films were measured in conformity with JIS K 6271 (2008). The measurement was performed with a DC voltage of 100 V applied.

[Dielectric Constant]

The dielectric constants of the manufactured dielectric films were measured. The measurement of the dielectric constant was performed by placing a dielectric film in a sample holder (12962A manufactured by Solartron Analytical Inc.) and using a dielectric constant measurement interface (1296 manufactured by the same as the above) and a frequency response analyzer (1255B manufactured by the same as the above) in combination (with a frequency of 100 Hz).

[Modulus of Elasticity]

The static shear moduli of the manufactured dielectric films were measured in accordance with JIS K 6254 (2003). An elongation ratio in a low-deformation tension test was set to 25%.

[Elongation at Break]

The elongations at break of the manufactured dielectric films were measured in accordance with JIS K 6251 (2010). The shape of a test piece was the dumbbell-shaped No. 5.

[Cross-Linking Property]

First, a test piece for evaluation was cut out of each of the manufactured dielectric films, and the mass of the test piece was measured. The test piece was then immersed in methyl ethyl ketone (MEK) at room temperature for 4 hours. Thereafter, the test piece was taken out and dried, and the mass thereof was measured. The ratio of the mass of the test piece after immersion (for MEK-insoluble parts) with respect to the mass of the test piece before immersion was calculated. When the ratio was 60% or more, cross-linking property was evaluated to be favorable (indicated by ○ in Table 1 below), and when the ratio was less than 60%, cross-linking property was evaluated to be unfavorable (indicated by × in the same table).

[Evaluation]

The measurement results of the dielectric films are shown in Table 1 together with the raw material compositions.

[Table 1]

| Raw material [parts by mass] | | Example 1 | Example 3 | Example 4 | Comparative Example 1 | Example 2 | Example 5 | Example 6 | Comparative Example 2 |
|---|---|---|---|---|---|---|---|---|---|
| Elastomer (HX-NBR) | | 100 | 100 | 100 | 100 | 100 | 100 | 100 | 100 |
| Dispersion liquid of barium titanate particles* 1 (median diamter: 20 nm) | | 120 | - | - | - | 53 | - | - | - |
| Barium titanate powder A*2 (average diameter: 150 nm) | | - | - | - | - | - | - | - | 53 |
| Barium titanate powder B (median diameter: 12 nm) | | - | 53 | - | - | - | 53 | - | - |
| Barium titanate powder C (median diameter: 60 nm) | | - | - | 53 | - | - | - | 53 | - |
| Cross-linking agent (Tetrakis(2-ethylhexyloxy)titanium) | | - | - | - | - | 5 | 5 | 5 | 5 |
| Evaluation of dielectric film | Volume resistivity [Ω·cm] | $5.16\times10^{13}$ | $1.20\times10^{13}$ | $7.50\times10^{13}$ | $1.61\times10^{11}$ | $4.62\times10^{12}$ | $5.10\times10^{13}$ | $1.00\times10^{13}$ | $6.17\times10^{11}$ |
| | Dielectric constant | 15.6 | 13.5 | 18.0 | 12.6 | 18.9 | 13.5 | 19.8 | 15.1 |
| | Modulus of elasticity [Mpa] | 9.80 | 7.90 | 5.50 | 2.18 | 6.22 | 9.80 | 6.50 | 3.23 |
| | Elongation at break [%] | 450 | 500 | 400 | 70 | 550 | 650 | 600 | 400 |
| | Cross-linking property | ○ | ○ | ○ | × | ○ | ○ | ○ | ○ |
| Evaluation of actuator | Dielectric breakdown strength [V/μm] | 50 | 55 | 50 | 30 | 65 | 80 | 70 | 30 |
| | Maximum generative force [Mpa] | 0.484 | 0.260 | 0.400 | 0.080 | 0.443 | 0.620 | 0.830 | 0.186 |

*1 "Application liquid specialty Titabari 20 nm" manufactured by JGC Catalysts and Chemicals Ltd.
*2 "BT-150" manufactured by KCM Corporation

In Table 1, first, Examples 1, 3, and 4 in which no cross-linking agent was blended are compared to Comparative Example 1. The dielectric films of Examples 1, 3, and 4 showed higher dielectric constants and higher moduli of elasticity and showed higher volume resistivities by about two digits as compared to the dielectric film of Comparative Example 1. Cross-linking did not proceed in the dielectric film of Comparative Example 1, whereas the cross-linking properties of Examples 1, 3, and 4 were favorable. The dielectric films of Examples 1, 3, and 4 also showed remarkably improved elongation at break. In other words, it can be seen that in the dielectric films of Examples 1, 3, and 4 a cross-linked structure is formed by the barium titanate particles and the elastomer.

Next, Examples 2, 5, and 6 in which a cross-linking agent was blended are compared to Comparative Example 2. Although both contain barium titanate particles, the dielectric films of Examples 2 and 6 showed higher values in all the volume resistivity, dielectric constant, modulus of elasticity, and elongation at break as compared to the dielectric film of Comparative Example 2. The dielectric film of Example 5 showed higher values in the volume resistivity, modulus of elasticity, and elongation at break, except the dielectric constant, as compared to the dielectric film of Comparative Example 2. Note that the dielectric constant of the dielectric film of Example 5 was higher than the dielectric constant of the dielectric film of Comparative Example 1, which does not contain barium titanate particles. In the dielectric film of Example 5, the particle diameter of the blended barium titanate particles was small so the effect of increasing the dielectric constant was small. However, when the particle diameter is small, a denser insulating network is formed so the effect of increasing the volume resistivity is large. Thus, the particle diameter of the barium titanate particles may be appropriately determined so that desired properties can be achieved.

The barium titanate particles blended into the dielectric film of Comparative Example 2 were baked after synthesis. Thus, it can be estimated that, in Comparative Example 2, the crystallinity of the barium titanate particles is high but the number of functional groups on the particle surface is small. The particle diameter of the barium titanate particles in Comparative Example 2 is large. Even when such barium titanate particles were blended, therefore, the effect of increasing the volume resistivity and dielectric constant was small. Here, the cross-linking property of the dielectric film of Comparative Example 2 was favorable. This is because a cross-linked structure was formed by the blended cross-linking agent.

<Manufacture of Actuator>

Using the manufactured dielectric film, an actuator was manufactured. First, carbon black was mixed and dispersed in an acrylic rubber polymer solution to prepare a conductive coating. Then, the conductive coating was screen-printed onto both the front side and the back side of the manufactured dielectric film to form electrodes. The actuators thus manufactured are each called "the actuator of Example 1" or the like, based on the type of the dielectric film. A three-layer structured dielectric layer was prepared by affixing a cation-immobilized dielectric layer to the front side of the dielectric film of Example 6 and affixing an anion-immobilized dielectric layer to the back side thereof. Using the prepared three-layer structured dielectric layer, an actuator was manufactured in the same manner as above. The manufactured actuator was named the actuator of Example 7. The actuators of Examples 1 to 7 are included in the transducer according to the present invention. The cation-immobilized dielectric layer and the anion-immobilized dielectric layer were prepared as follows.

[Cation-Immobilized Dielectric Layer]

The cation-immobilized dielectric layer was prepared as follows. First, 0.02 mol of acetylacetone was added to 0.01 mol of tetra-i-propoxy titanium that is an organometallic compound to obtain a chelate compound. Subsequently, 0.002 mol of a reactive ionic liquid of Formula (2) below, 5 ml (0.083 mol) of isopropyl alcohol (IPA), 10 ml (0.139 mol) of methyl ethyl ketone (MEK), and 0.04 mol of water were added to the obtained chelate compound to obtain a sol containing $TiO_2$ particles to which cations are immobilized (cation-immobilized particles) and anions. The obtained sol was left at rest for two hours at a temperature of 40°C to perform aging treatment.

Subsequently, 100 parts by mass of carboxy group-modified hydrogenated nitrile rubber ("Therban (trademark) XT8889" manufactured by LANXESS) and 10 parts by mass of silica ("Aerosil (trademark) 380" manufactured by Nippon Aerosil Co., Ltd.) were mixed and kneaded by a roll mill. The kneaded material was dissolved in acetylacetone. 100 parts by pass of the solution and 20 parts by mass of the sol after aging were mixed, and further, 3 parts by mass of an acetylacetone solution of tetrakis(2-ethylhexyloxy)titanium (with a concentration of 20% by mass) was added thereto as a cross-linking agent to prepare a mixed solution. The prepared mixed solution was applied onto a substrate and dried, followed by heating at 150°C for about 60 minutes to obtain a cation-immobilized dielectric layer. The film thickness of the cation-immobilized dielectric layer was about 10 μm, and the content of cation-immobilized particles was 6.6 parts by mass.

Formula (2)

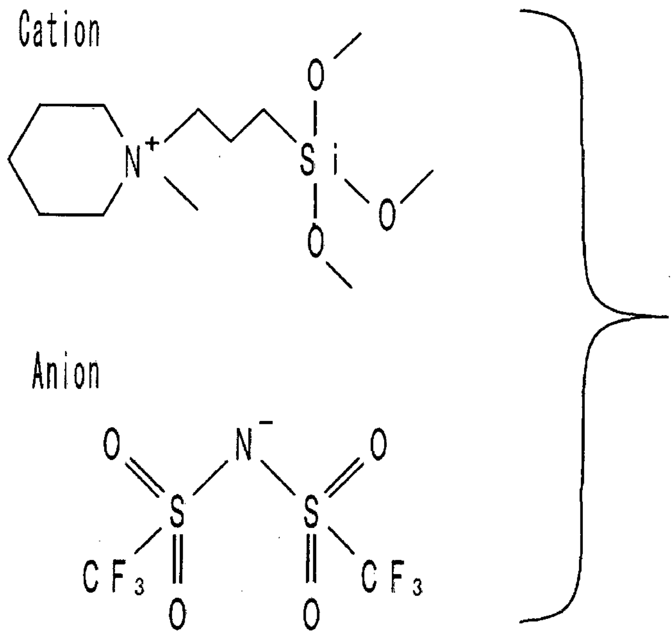


(2)

[Anion-Immobilized Dielectric Layer]

An anion-immobilized dielectric layer with a thickness of about 10 μm was prepared in the same manner as the above cation-immobilized dielectric layer except that the type of the reactive ionic liquid was changed to the type of Formula (3) below. A sol obtained in the production process contains $TiO_2$ particles to which anions are immobilized (anion-immobilized particles) and cations.

Formula (3)

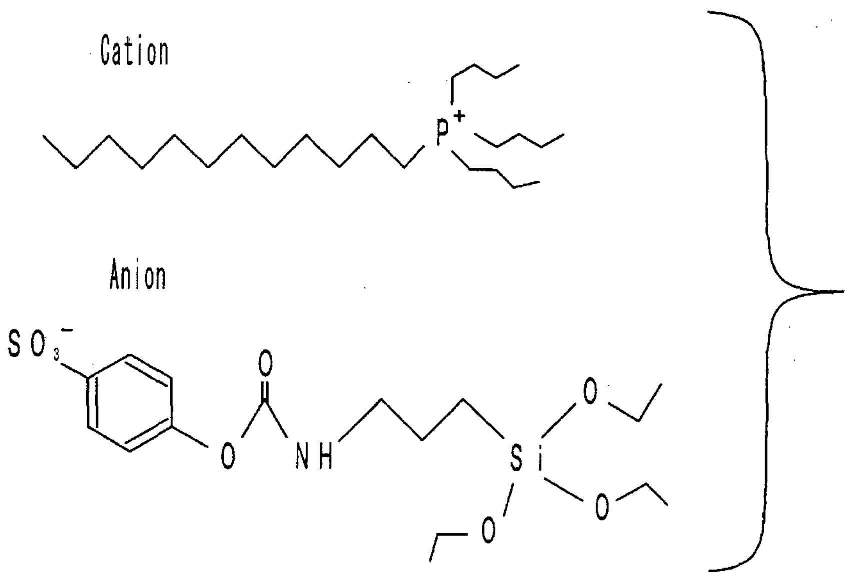


(3)

<Evaluation of Actuator>

The dielectric breakdown strength and maximum generative stress of each of the manufactured actuators were measured. First, a measuring apparatus and a measuring method will be described. FIG. 2 illustrates a front-side elevation

view of an actuator mounted on the measuring apparatus. FIG. 3 illustrates a III-III sectional view of FIG. 2.

As illustrated in FIG. 2 and FIG. 3, the upper end of an actuator 5 is held by an upper chuck 52 of the measuring apparatus. The lower end of the actuator 5 is held by a lower chuck 53. The actuator 5 is arranged between the upper chuck 52 and the lower chuck 53 while being extended in advance in the up and down direction (with an elongation ratio of 25%). A load cell (not shown) is arranged over the upper chuck 52.

The actuator 5 includes a dielectric film 50 and a pair of electrodes 51 a, 51b. The dielectric film 50 is a rectangular thin film of 50 mm long, 25 mm wide, and about 20 μm thick in a natural state. In the actuator of Example 7, the dielectric film 50 has a three-layer structure of cation-immobilized dielectric layer/dielectric film/anion-immobilized dielectric layer (with a total thickness of 40 μm). The electrodes 51a, 51b are arranged so as to face each other in the front and back direction across the dielectric film 50. Each of the electrodes 51 a, 51b has the shape of a rectangular thin film of 40 mm long, 25 mm wide, and 10 μm thick in a natural state. The electrodes 51a, 51b are arranged so as to be displaced from each other by 10 mm in the up and down direction. In other words, the electrodes 51a, 51b overlap, with the dielectric film 50 interposed therebetween, in a range of 30 mm long and 25 mm wide. An electric wire (not shown) is connected to the lower end of the electrode 51a. Similarly, an electric wire (not shown) is connected to the upper end of the electrode 51b. The electrodes 51a, 51b are each connected to a power source (not shown) through the corresponding electric wire.

When a voltage is applied between the electrodes 51a, 51b, an electrostatic attraction occurs between the electrodes 51a, 51b to compress the dielectric film 50. The thickness of the dielectric film 50 thereby decreases, and the dielectric film 50 expands in the extension direction (the up and down direction). Through the expansion of the dielectric film 50, an extension force in the up and down direction decreases. The extension force decreased during voltage application was measured by the load cell to be considered as a generative stress. The measurement of the generative stress was performed with the applied voltage increased stepwise until the dielectric film 50 was broken. A generative stress immediately before the dielectric film 50 was broken was considered as the maximum generative stress. A value obtained by dividing the voltage value at that time by the film thickness of the dielectric film 50 (in the actuator of Example 7, the total thickness of the cation-immobilized dielectric layer/dielectric film/anion-immobilized dielectric layer) was considered as dielectric breakdown strength. Table 1 collectively shows the measurement results of the dielectric breakdown strength and maximum generative stress in the actuators of Examples 1 to 6 and Comparative Examples 1 and 2.

In Table 1, Examples 1, 3, and 4 and Comparative Example 1 are compared. In the actuators of Examples 1, 3, and 4, the dielectric breakdown strength and the maximum generative stress were considerably higher than those of the actuator of Comparative Example 1. Next, Examples 2, 5, and 6 and Comparative Example 2 are compared. In this case also, in the actuators of Examples 2, 5, and 6, the dielectric breakdown strength and the maximum generative stress were considerably higher than those of the actuator of Comparative Example 2. The dielectric films constituting the actuators of Examples 1 and 2 are manufactured by the sol-gel method using a high-concentration precursor and contain barium titanate particles with a crystallinity of 95%. The dielectric films constituting the actuators of Examples 3 to 6 are manufactured by the hydrothermal synthesis method using supercritical water and contain barium titanate particles with a crystallinity of 98%. These barium titanate particles have functional groups (-OH, -OR) that can react with the functional group (-COOH) of HX-NBR. Therefore, regardless of the presence or absence of a cross-linking agent, a cross-linked structure with the elastomer and the barium titanate particles was formed, thereby significantly improving dielectric breakdown strength of the dielectric film. In contrast, it is considered that the number of functional groups that can react with the functional group of HX-NBR is small on the surface of the barium titanate particles blended into the dielectric film of Comparative Example 2. Therefore, although cross-linking proceeded through the blended cross-linking agent, an insulating network through bonds between the barium titanate particles and the elastomer was not formed, and resistance to dielectric breakdown of the dielectric film did not improved.

The dielectric breakdown strength and the maximum generative stress of the actuator of Example 7, in which the cation-immobilized dielectric layer and the anion-immobilized dielectric layer were stacked with the dielectric film of Example 6 sandwiched therebetween, were 100 V/μm and 2.01 MPa, respectively. It has been confirmed that when an ion-immobilized layer is thus interposed between an electrode and the dielectric film, resistance to dielectric breakdown possessed by the dielectric film can be satisfactorily exhibited, which improves resistance to dielectric breakdown of the actuator. It has also been confirmed that the generative stress increased.

From the foregoing, it has been confirmed that by employing the dielectric film according to the present invention, an actuator that is high in resistance to dielectric breakdown and that can output a large force can be achieved.

INDUSTRIAL APPLICABILITY

The transducer employing the dielectric film according to the present invention can be widely used for an actuator, a sensor, and the like that perform conversion between mechanical energy and electric energy and a speaker, a microphone, a noise canceller, and the like that perform conversion between acoustic energy and electric energy. In

particular, the transducer is suitable as a flexible actuator that is used in: an artificial muscle for use in industrial, medical and welfare robots, power-assisted suits, and the like; a small-sized pump for use in cooling electronic components, for medical use, and the like; and medical instruments and the like.

## Claims

1. A dielectric film for use in a transducer, **characterized by** comprising:

   an elastomer; and
   barium titanate particles with a crystallinity of 80% or more, wherein
   the elastomer and each of the barium titanate particles each have a functional group, the functional groups optionally react with each other, and through the reaction of the functional groups, a cross-linked structure with the elastomer and the barium titanate particles is formed.

2. The dielectric film according to claim 1, wherein the particle diameter of the barium titanate particles is 8 nm or more and 120 nm or less.

3. The dielectric film according to claim 1 or 2, wherein the functional group of each of the barium titanate particles includes at least one of an alkoxy group and a hydroxy group.

4. The dielectric film according to any one of claims 1 to 3, wherein the barium titanate particles are manufactured as follows: a mixed solution of water and a polar organic solvent in which a concentration of the polar organic solvent is 15% by mole or more is added dropwise to a precursor solution with a concentration of an alkoxide containing barium and titanium of 0.5 mol/l or more such that a molar ratio of the water in the mixed solution is at least four times a molar ratio of the titanium in the precursor solution, and the alkoxide is hydrolyzed and then maintained at a temperature of 10°C or more.

5. The dielectric film according to any one of claims 1 to 4, wherein the functional group of the elastomer is one or more selected from a hydroxy group, an amino group, a carboxy group, a thiol group, and a halogenated alkyl group.

6. The dielectric film according to any one of claims 1 to 5, wherein the elastomer is one or more selected from nitrile rubber, hydrogenated nitrile rubber, acrylic rubber, natural rubber, isoprene rubber, ethylene-propylene-diene copolymer, ethylene-vinyl acetate copolymer, ethylene-vinyl acetate-acrylic ester copolymer, butyl rubber, styrene-butadiene rubber, fluorocarbon rubber, silicone rubber, epichlorohydrin rubber, chloroprene rubber, chlorinated polyethylene, chlorosulfonated polyethylene, and urethane rubber.

7. A transducer **characterized by** comprising:

   the dielectric film as claimed in any one of claims 1 to 6; and
   a plurality of electrodes that are arranged with the dielectric film interposed therebetween.

【FIG. 1】

(a)

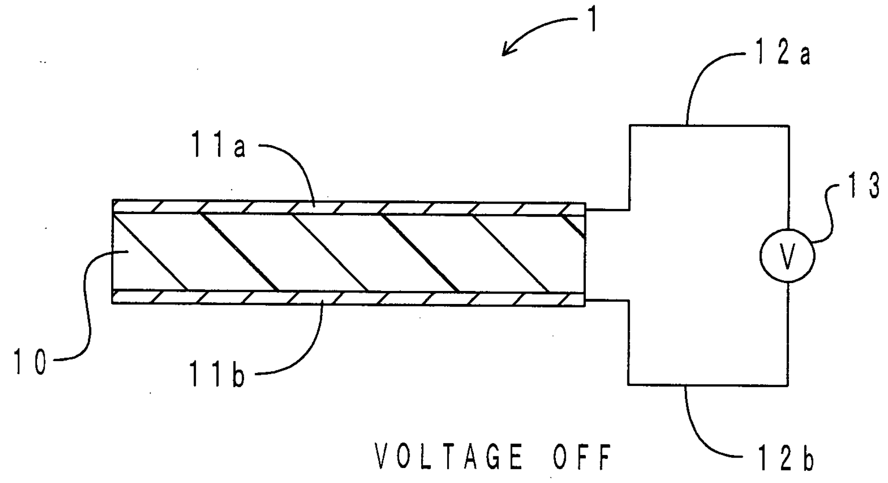
1
12a
11a
13
V
10
11b
VOLTAGE OFF
12b

(b)

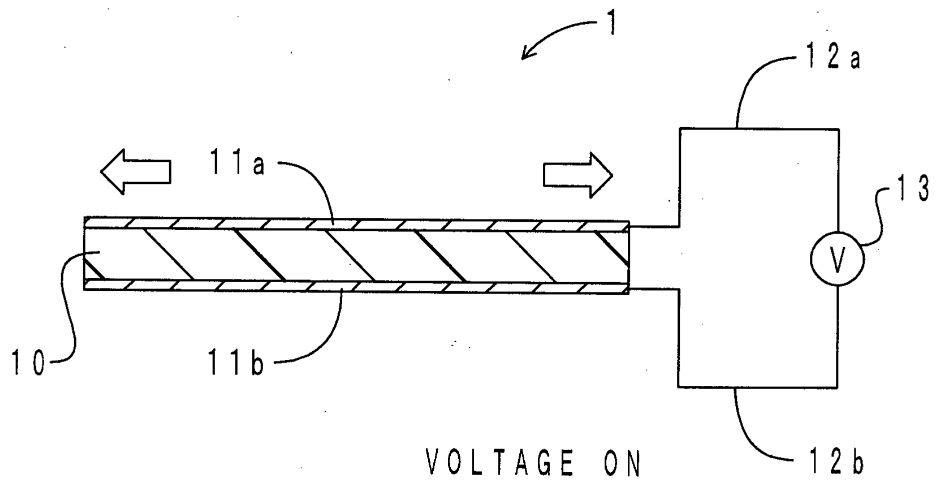
1
12a
11a
13
V
10
11b
VOLTAGE ON
12b

【FIG. 2】

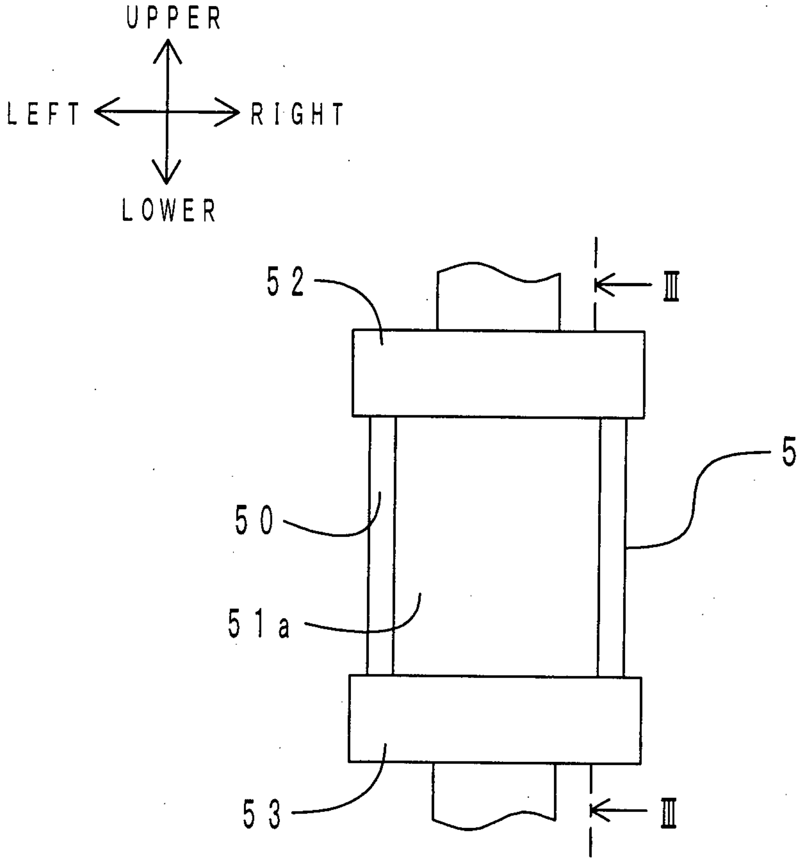

【FIG. 3】

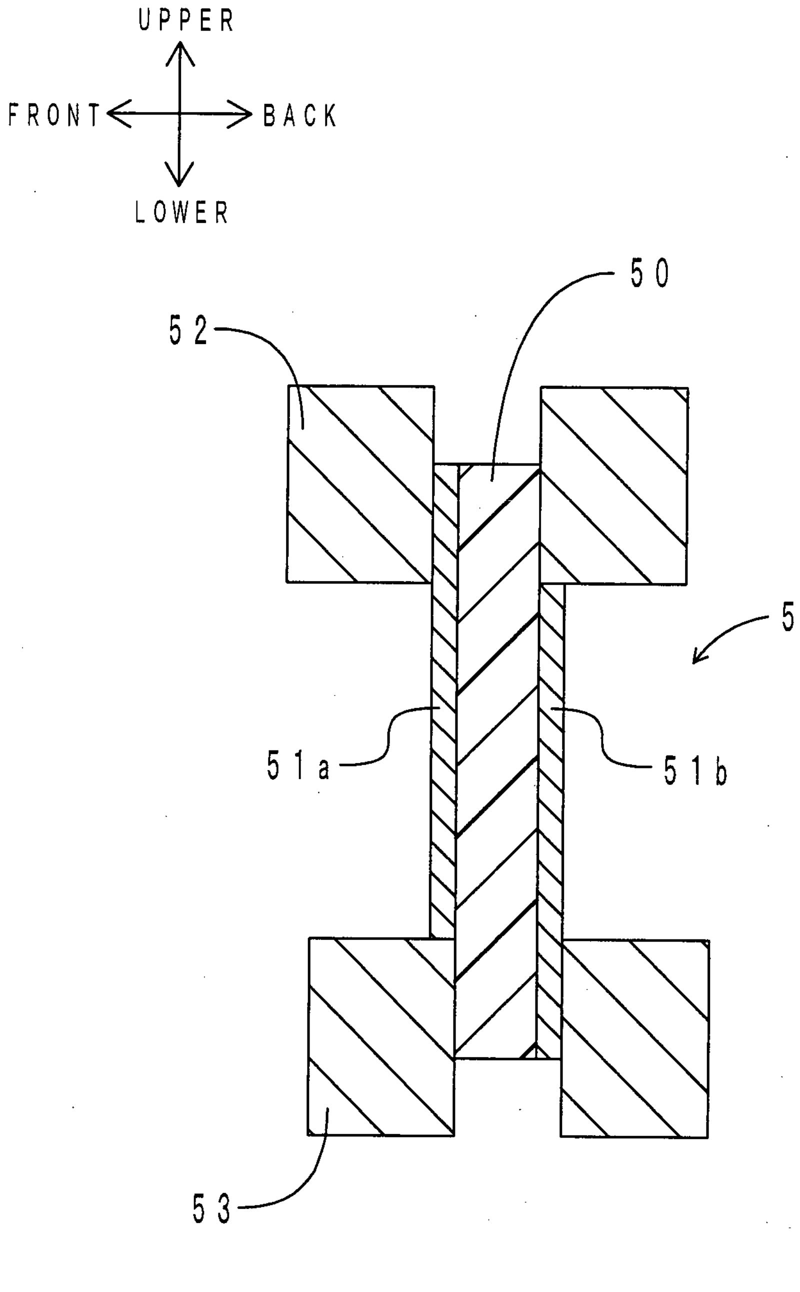

【FIG. 4】

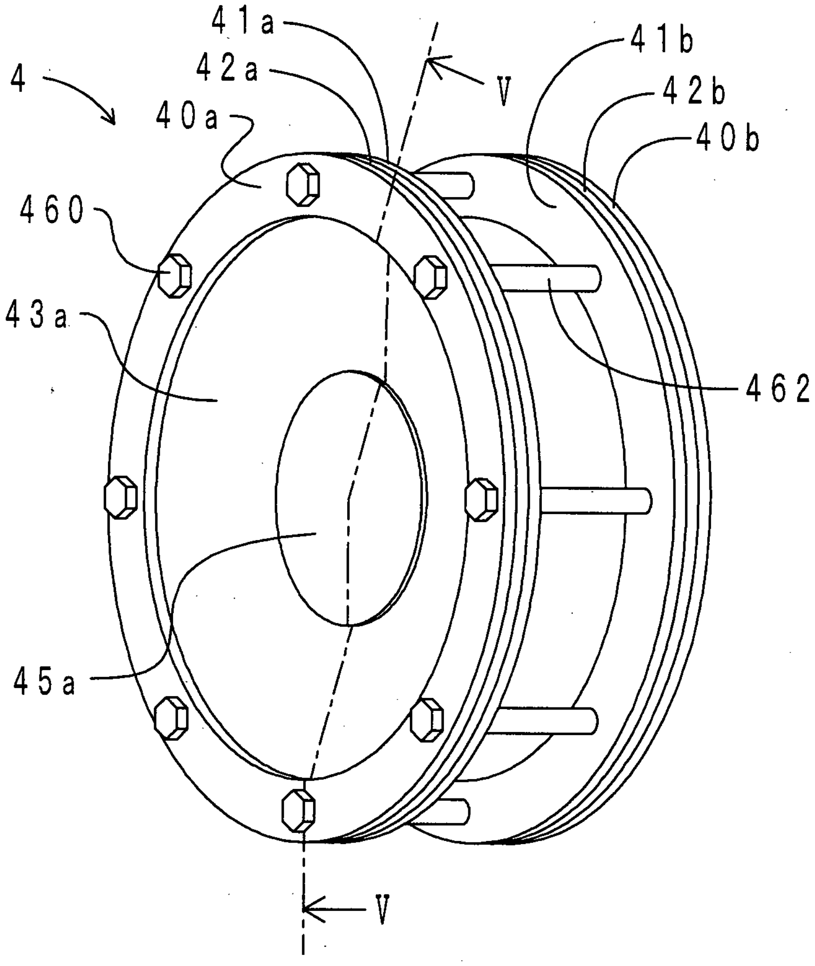

【FIG. 5】

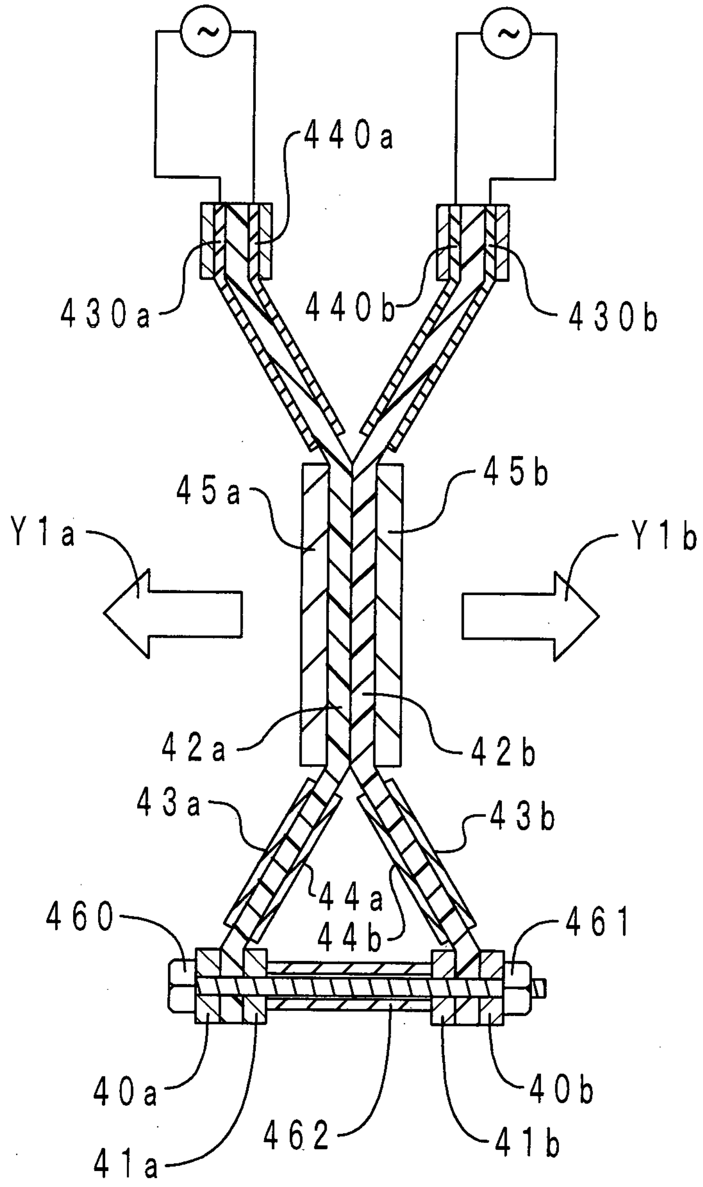
440a
430a
440b
430b
45a
45b
Y1a
Y1b
42a
42b
43a
43b
44a
44b
460
461
40a
40b
41a
462
41b

## INTERNATIONAL SEARCH REPORT

International application No.
PCT/JP2012/076693

A. CLASSIFICATION OF SUBJECT MATTER
*H01B3/00*(2006.01)i, *C08J5/18*(2006.01)i, *C08K3/24*(2006.01)i, *C08L15/00*(2006.01)i, *H01B3/12*(2006.01)i, *H01B3/28*(2006.01)i, *H01L41/08*(2006.01)i, *H01L41/193*(2006.01)i, *H01L41/26*(2006.01)i, *H02N11/00*(2006.01)i,

According to International Patent Classification (IPC) or to both national classification and IPC

B. FIELDS SEARCHED

Minimum documentation searched (classification system followed by classification symbols)
H01B3/00, C08J5/18, C08K3/24, C08L15/00, H01B3/12, H01B3/28, H01L41/08, H01L41/193, H01L41/26, H02N11/00, H04R17/00

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | WO 2011/033956 A1 (Tokai Rubber Industries, Ltd.), 24 March 2011 (24.03.2011), paragraphs [0010], [0029] to [0032]; example 11 & JP 2011-84712 A & EP 2390998 A1 & CN 102405590 A & KR 10-2012-0042723 A | 1-7 |
| A | WO 2011/118315 A1 (Tokai Rubber Industries, Ltd.), 29 September 2011 (29.09.2011), entire text & CN 102575069 A & KR 10-2012-0073283 A | 1-7 |

☒ Further documents are listed in the continuation of Box C.  ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 07 December, 2012 (07.12.12) | 18 December, 2012 (18.12.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No. PCT/JP2012/076693

C (Continuation). DOCUMENTS CONSIDERED TO BE RELEVANT

| Category* | Citation of document, with indication, where appropriate, of the relevant passages | Relevant to claim No. |
|---|---|---|
| A | JP 2011-201993 A (Tokai Rubber Industries, Ltd.), 13 October 2011 (13.10.2011), entire text (Family: none) | 1-7 |
| A | JP 2009-173691 A (Tokai Rubber Industries, Ltd.), 06 August 2009 (06.08.2009), entire text (Family: none) | 1-7 |

Form PCT/ISA/210 (continuation of second sheet) (July 2009)

**INTERNATIONAL SEARCH REPORT**

International application No.
PCT/JP2012/076693

Continuation of A. CLASSIFICATION OF SUBJECT MATTER
(International Patent Classification (IPC))

*H04R17/00*(2006.01)i

(According to International Patent Classification (IPC) or to both national classification and IPC)

Form PCT/ISA/210 (extra sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2003506858 W
- JP 2009227985 A
- JP 2011084712 A
- JP 2005306691 A
- JP 3925932 B